# EUROPÄISCHE PATENTANMELDUNG

(11) **EP 3 882 979 A1**
(43) Veröffentlichungstag der Anmeldung: **22.09.2021**
(21) Anmeldenummer: 21000069.1
(22) Anmeldetag: 12.03.2021
(51) Int. Cl.: H01L 29/861, H01L 29/20, H01L 29/205, H01L 29/06, H01L 29/04, H01L 23/29, H01L 23/31, H01L 29/40, H01L 21/329

(54) **STAPELFÖRMIGE HOCHSPERRENDE III-V-HALBLEITERLEISTUNGSDIODE**

(30) Priorität: 20.03.2020 DE 102020001835
(71) Anmelder: AZUR SPACE Solar Power GmbH, 74072 Heilbronn (DE)
(72) Erfinder: Strobl, Gerhard, 70439 Stuttgart (DE)
(74) Vertreter: Koch Müller Patentanwaltsgesellschaft mbH

(57) **Zusammenfassung**

Stapelförmige hochsperrende III-V-Halbleiterleistungsdiode, aufweisend ein zweite metallische Anschlusskontaktschicht, ein hochdotiertes Halbleiterkontaktgebiet, ein niedrig dotiertes Driftgebiet mit einer Schichtdicke von 10 µm - 100 µm, eine hochdotierte Halbleiterkontaktschicht und eine erste metallisches Anschlusskontaktschicht, wobei die vorgenannten Gebiete und Schichten in der genannten Reihenfolge angeordnet sind, das Halbleiterkontaktgebiet sich wannenförmig in das Driftgebiet hinein erstreckt, die Unterseite der zweiten metallischen Anschlusskontaktschicht stoffschlüssig mit der Oberseite des Halbleiterkontaktgebiets verbunden ist und die erste Anschlusskontaktschicht mit einer Unterseite der Halbleiterkontaktschicht stoffschlüssig verbunden ist, wobei die III-V-Halbleiterleistungsdiode eine dotierte III-V-Halbleiterpassivierungsschicht aufweist, die III-V-Halbleiterpassivierungsschicht in einem ersten Abstand von mindestens 0,5 µm oder von mindestens 5 µm oder von mindestens 10 µm oder von mindestens 20 µm oder von mindestens 40 µm zu dem hochdotierten Halbleiterkontaktgebiet auf der Oberseite des Driftgebiets angeordnet und mit der Oberseite des Driftgebiets stoffschlüssig verbunden ist.

## Beschreibung

Die Erfindung betrifft eine stapelförmige hochsperrende III-V-Halbleiterleistungsdiode.

Aus "GaAs Power Devices" von German Ashkinazi, ISBN 965-7094-19-4, Seite 8 und 9 ist eine hochspannungsfeste Halbleiterdiode aus GaAs mit p⁺ - n - n⁺ bekannt. Auf den Seiten 23 bis 26 werden GaAs Schottky-Dioden beschrieben.

Weitere hochspannungsfeste III-V- Halbleiterdioden und entsprechende Herstellungsverfahren sind auch aus den Druckschriften DE 10 2016 013 540 A1, DE 10 2016 013 541 A1, DE 10 2016 015 056 A1, DE 10 2017 002 935 A1 und DE 10 2017 002 936 A1 bekannt.

Gattungsgemäße Dioden weisen Durchbruchspannungen oberhalb von 200V auf und sollten neben einer niedrigen Vorwärtsspannung auch einen geringen Serienwiderstand aufweisen, um die Verlustleistung zu reduzieren. Des Weiteren sollten die Dioden in Sperrrichtung möglichst geringe Leckströme von unterhalb 1 µA aufweisen.

Nachteilig an den beschriebenen Strukturen sind jedoch insbesondere die Rest- bzw. Leckströme, die bei einem Betrieb in Sperrrichtung, insbesondere über die Ränder der planaren p-n Übergänge bzw. der Mesa-Strukturen auftreten.

Vor diesem Hintergrund besteht die Aufgabe der Erfindung darin, eine Vorrichtung anzugeben, die den Stand der Technik weiterbildet. Ziel ist insbesondere eine Reduktion von Sperrströmen und eine Steigerung der Durchbruchspannung.

Die Aufgabe wird durch eine Stapelförmige hochsperrende III-V-Halbleiterleistungsdiode mit den Merkmalen des Patentanspruchs 1 gelöst. Vorteilhafte Ausgestaltungen der Erfindung sind Gegenstand von Unteransprüchen.

In dem Gegenstand der Erfindung wird eine stapelförmige hochsperrende III-V-Halbleiterleistungsdiode bereitgestellt.

Die stapelförmige hochsperrende III-V-Halbleiterleistungsdiode weist eine zumindest gebietsweise ausgebildete zweite metallische Anschlusskontaktschicht und ein hochdotiertes Halbleiterkontaktgebiet eines ersten Leitfähigkeitstyps mit einer Dotierstoffkonzentration von mindestens 1•10¹⁸ cm⁻³ und mit einer ersten Gitterkonstanten sowie einer ersten Energiebandlücke auf.

Außerdem weist die stapelförmige hochsperrende III-V-Halbleiterleistungsdiode ein Driftgebiet des ersten Leitfähigkeitstyps oder eines zweiten Leitfähigkeitstyps mit einer Dotierstoffkonzentration zwischen 8•10¹² - 1•10¹⁴ cm⁻³ und einer Schichtdicke von 10 µm - 100 µm und eine erste metallisches Anschlusskontaktschicht auf.

Die vorgenannten Gebiete und Schichten sind in der genannten Reihenfolge angeordnet, wobei das Halbleiterkontaktgebiet wannenförmig mit einer Oberseite und einer sich in das Driftgebiet hinein erstreckenden Tiefe ausgebildet ist.

Die Unterseite der zweiten metallischen Anschlusskontaktschicht ist stoffschlüssig mit der Oberseite des Halbleiterkontaktgebiets verbunden.

Die hochsperrende III-V-Halbleiterleistungsdiode weist außerdem eine III-V-Halbleiterpassivierungsschicht mit der ersten Gitterkonstanten und einer von der ersten Energiebandlücke abweichenden zweiten Energiebandlücke auf, wobei die III-V-Halbleiterpassivierungsschicht den ersten oder den zweiten Leitfähigkeitstyp und eine Dotierstoffkonzentration von 1•10¹⁴ - 1•10¹⁸ cm⁻³ aufweist.

Die III-V-Halbleiterpassivierungsschicht ist in einem ersten Abstand von mindestens 0,2 µm oder von mindestens 5 µm oder von mindestens 10 µm oder von mindestens 20 µm oder von mindestens 40 µm zu der Oberseite des hochdotierten Halbleiterkontaktgebiets auf der Oberseite des Driftgebiets angeordnet und mit der Oberseite des Driftgebiets stoffschlüssig verbunden.

Vorzugsweise weist die III-V-Halbleiterpassivierungsschicht InGaP oder AlGaAs oder InGaAsP auf oder besteht aus InGaP oder AlGaAs oder InGaAsP.

Es sei angemerkt, dass die metallischen Anschlusskontaktschichten jeweils elektrisch sehr gut leitfähig sind. Vorzugsweise bestehen die metallischen Anschlusskontaktschichten aus einer oder mehreren Metallschichten, wobei die Metallschichten insbesondere Ge und/oder Au und/oder Pd und / oder Ag umfassen.

Die metallischen Anschlusskontaktschichten stellen einen elektrisch niederohmigen Kontakt zu dem Halbleiterkontaktgebiet bzw. zu einer weiteren Halbleiterschicht, z.B. einer hochdotierten Halbleiterkontaktschicht oder der Driftschicht, her.

Es versteht sich, dass die jeweiligen Halbleiterschichten/gebiete jeweils an einer Oberseite oder an einer Unterseite der III-V Halbleiterleistungsdioden unmittelbar angrenzend zu der jeweiligen metallischen Anschlusskontaktschicht ausgebildet sind.

Die erste Anschlusskontaktschicht ist vorzugsweise flächig auf einer Unterseite der vorausgehenden Halbleiterschicht ausgebildet.

Des Weiteren versteht es sich, dass die Anschlusskontaktschichten vorzugsweise mittels Bonddrähte mit Kontaktfingern, den sogenannten Pins, und/oder mittels Kontaktpunkten, sogenannten Bumps verschaltet sind, wobei die Halbleiterleistungsdioden auf einem Träger beispielsweise in Form eines Leadframes angeordnet sind.

Das Halbleiterkontaktgebiet ist als in das schichtförmig ausgebildete Driftgebiet hineinreichendes Gebiet ausgebildet, so dass die Oberseite des Halbleiterkontaktgebiets und die Oberseite des Driftgebiets eine gemeinsame Oberfläche ausbilden bzw. sich die Oberseite des Halbleiterkontaktgebiets inselförmig innerhalb der Oberseite des Driftgebiets befindet.

Das Halbleiterkontaktgebiet reicht von der Oberseite bis zu einer maximalen Tiefe in das Driftgebiet hinein, wobei es sich versteht, dass die Schichtdicke des Driftgebiets deutlich größer als die Tiefe des Halbleiterkontaktgebiets.

In einer Ausführungsform weist die von der Oberseite des Driftgebiets und der Oberseite des Halbleiterkontaktgebiets ausgebildete Oberfläche aufgrund von Ätzprozessen Stufen auf und ist ansonsten überwiegend plan ausgebildet.

Das Halbleiterkontaktgebiet ist vorzugsweise mittels Implantation oder Diffusion erzeugt.

Die weiteren Halbleitergebiete bzw. Halbleiterschichten, z.B. das Driftgebiet und/oder die III-V-Halbleiterpassivierungsschicht, sind vorzugsweise teilweise oder vollständig epitaktisch, z.B. mittels MOVPE oder LPE, erzeugt.

Das Driftgebiet ist beispielsweise durch epitaktisches Aufwachsen auf einer Substratschicht oder auf einer Pufferschicht oder auf einer Halbleiterkontaktschicht erzeugt und/oder die III-V-Halbleiterpassivierungsschicht entsprechend durch Aufwachsen auf dem Driftgebiet. Eine hochdotierte Halbleiterkontaktschicht und/oder eine Pufferschicht sind bevorzugt ebenfalls durch epitaktisches Aufwachsen auf einer vorausgehenden Schicht erzeugt.

Alternativ oder ergänzend sind eine oder mehrere Schichten der stapelförmigen hochsperrenden III-V-Halbleiterleistungsdiode mittels eines Wafer-Bonds miteinander verbunden.

Auch sei angemerkt, dass der Ausdruck "Halbleiterschicht" bzw. "Halbleiterkontaktschicht" mit dem Ausdruck "Halbleiterbereich" bzw. "Halbleiterkontaktgebiet" vorzugsweise synonym verwendet wird. Jedoch wird mit dem Ausdruck "Halbleitergebiet" eine im Allgemeinen wannenförmige Ausbildung des Zwischenbereichs und mit dem Ausdruck "Halbleiterschicht" im Allgemeinen eine Schicht zumindest mit einer planen Unterseite und einer planen Oberseite bezeichnet.

Vorzugsweise sind die III-V Halbleiterschichten jeweils zueinander zumindest teilweise planar oder teilweise wannenförmig ausgebildet, wobei die laterale Ausbildung der jeweiligen III-V Halbleiterschichten für die planare Anordnung vorzugsweise gleich groß ist.

Es versteht sich, dass nur die Halbleiterbereiche bzw. Halbleiterschichten oder zumindest ein Großteil der Halbleiterbereich bzw. Halbleiterschichten der hochsperrenden III-V-Halbleiterdiode aus III-V-Materialien, z.B. GaAs, AlGaAs, InGaP, GaAsP, InGaAs, InGaAsP oder InP bestehen.

In einer Weiterbildung weist die hochsperrende III-V-Halbleiterdiode zusätzlich Halbleiterschichten aus anderen Halbleitermaterialien oder zusätzliche Schichten aus anderen nicht-Halbleiter-Materialien auf.

Außerdem versteht es sich, dass ein aus einem III-V-Material bestehendes Halbleitergebiet bzw. eine Halbleiterschicht nur im Wesentlichen aus III-V-Material bestehen muss bzw. neben einem III-V-Material, also einem Material welches einen oder mehrere Elemente der III. und/oder V. Hauptgruppe umfasst, gegebenenfalls noch Verunreinigungen und/oder Dotierstoffe und/oder Störstellen aufweist.

Entsprechendes gilt für ein aus GaAs oder einer anderen ausdrücklich genannten Materialkombination bestehenden Halbleitergebiet bzw. eine Halbleiterschicht. Weist eine Schicht eine ausdrücklich genannte Materialkombination auf, so wird damit ausgedrückt, dass das Material der Schicht im Wesentlichen aus einer Verbindung der ausdrücklich genannten Materialien und gegebenenfalls weiteren Elementen der III. und/oder V. Hauptgruppe besteht. Eine GaAs aufweisende Schicht lässt sich beispielsweise als eine InGaAs-Schicht ausbilden.

In einer Ausführungsform bestehen das Driftgebiet und das Halbleiterkontaktgebiet und/oder eine hochdotierte Halbleiterkontaktschicht aus GaAs oder weisen einen Indium-Gehalt von höchstens 30% auf und die III-V-Halbleiterpassivierungsschicht besteht vorzugsweise aus InGaP.

Es versteht sich auch, dass die hochsperrende III-V-Halblelterdiode entweder als eine n-auf-p oder als eine p-auf-n Struktur ausgebildet ist. Entsprechend ist entweder der erste Leitfähigkeitstyp p und der zweite Leitfähigkeitstyp n oder vice versa.

Die Begriffe "unten" und "oben" bzw. "unterhalb" und "oberhalb" dienen lediglich dazu, die Anordnung der einzelnen Schichten und Gebiete relativ zueinander zu beschreiben und geben keine absolute Richtung an.

Gegebenenfalls durch den lokalen p-n Übergang zwischen dem Halbleiterkontaktgebiet und der Driftschicht sowie durch die III-V-Halbleiterpassivierungsschicht werden Leckströme im Randbereich bzw. über den Rand verlaufende Strompfad unterdrückt.

Untersuchungen haben gezeigt, dass zusätzlich zu der Dicke des Driftgebiets die Durchbruchspannung auch von dem ersten Abstand zwischen der III-V-Halbleiterpassivierungsschicht und dem zweiten Halbleiterkontaktgebiet bestimmt wird. Mit dem erfindungsgemäßen hochsperrenden Bauelement lassen sich Durchbruchfeldstärken von bis zu 40 V/µm und sehr zuverlässig Durchbruchfeldstärken von über 30 V/µm erreichen.

III-V-Halbleiter, insbesondere GaAs, liefern eine besonders hohe Elektronenbeweglichkeit von 8800 Vs/cm bei einer Dotierung von kleiner als 1•10¹⁵ cm⁻³, wobei die Elektronenbeweglichkeit bei InGaAs von ca. 12.000 Vs/cm bei einer Dotierung von kleiner als 1•10¹⁵ cm⁻³ liegt.

Vorteile der erfindungsgemäßen Halbleiterstruktur sind ein besonders geringer Sperrstrom und eine hohe Durchbruchspannung. Insbesondere weist die Durchbruchkennlinie einen idealen Verlauf auf.

Ein anderer Vorteil ist, dass mittels des Abstandes zwischen der Passivierungsschicht und dem Halbleiterkontaktgebiet auch bei hohen Sperrspannungen von oberhalb 400 V besonders niedriger Sperrströme kleiner 1 µA auftreten. Insbesondere liegen die Sperrströme in einem Bereich zwischen 0,5 nA und 50 nA oder unterhalb von 100 nA.

Ein anderer Vorteil ist, dass bei den III-V Halbleiterleistungsdioden im Vergleich zu Silizium oder teilweise auch SiC insbesondere die Elektronen eine kleinere effektive Masse bzw. eine höhere Beweglichkeit aufweisen.

Auch lassen sich mit den III-V Halbleiterleistungsdioden im Vergleich zu Si höhere Temperaturen an den p/n-Übergängen erreichen, ohne dass die III-V Halbleiterdioden zerstört werden. So lassen sich III-V Halbleiterdioden bis zu Temperaturen von 300°C, d.h. auch in heißen Umgebungen, einsetzen.

Ein weiterer Vorteil im Vergleich zu SiC ist, dass sich III-V Halbleiterleistungsdioden wesentlich kostengünstiger als Halbleiterstrukturen aus SiC mit vergleichbaren elektrischen Eigenschaften herstellen lassen.

In einer ersten Ausführungsform weist die III-V-Halbleiterpassivierungsschicht eine Schichtdicke von 0,1 µm - 1 µm auf.

Vorzugsweise weist die III-V-Halbleiterpassivierungsschicht eine höhere Bandlücke als das darunterliegende Absorptionsgebiet auf.

In einer anderen Ausführungsform besteht die III-V-Halbleiterpassivierungsschicht aus InGaP oder AlGaAs oder InGaAsP oder weist InGaP oder AlGaAs oder InGaAsP auf.

In einer weiteren Ausführungsform beträgt der erste Abstand der III-V-Halbleiterpassivierungsschicht zu dem Halbleiterkontaktgebiet mindestens 50% oder mindestens 75% der Schichtdicke des Driftgebiets.

In einer anderen Weiterbildung umschließt die III-V-Halbleiterpassivierungsschicht in einer Projektion senkrecht zu der Oberseite des Halbleiterkontaktgebiets das Halbleiterkontaktgebiet vollständig oder zumindest zu 70% oder zu 90%.

In einer anderen Weiterbildung ist die III-V-Halbleiterpassivierungsschicht ist von einer weiteren Passivierungsschicht, z.B. eine Nitridschicht oder einer Oxynitridschicht oder einer Oxidschicht oder einer Polyimidschicht, überdeckt.

Die weitere Passivierungsschicht erstreckt sich vorzugsweise über einen das Halbleiterkontaktgebiet umgebenden und nicht von der III-V-Halbleiterpassivierungsschicht überdeckten Teil der Oberseite des Driftgebiets sowie über einen Randbereich der Oberseite des Halbleiterkontaktgebiets und über zu dem Halbleiterkontaktgebiet ausgerichteten Seitenflächen der weiteren III-V-Halbleiterpassivierungsschicht.

In einer Ausführungsform weist die III-V-Halbleiterpassivierungsschicht den gleichen Leitfähigkeitstyp wie das Driftgebiet auf. Die III-V-Halbleiterpassivierungsschicht und das Driftgebiet sind also entweder beide p-dotiert oder beide n-dotiert ausgebildet.

Alternativ weist die III-V-Halbleiterpassivierungsschicht einen von dem Driftgebiet abweichenden Leitfähigkeitstyp auf.

In einer Weiterbildung ist die III-V-Halbleiterpassivierungsschicht mit dem von dem Driftgebiet abweichenden Leitfähigkeitstyp stoffschlüssig mit einer zumindest gebietsweise ausgebildeten dritten metallischen Anschlusskontaktschicht verbunden.

Insbesondere weist das Driftgebiet den ersten Leitfähigkeitstyp und die III-V-Halbleiterpassivierungsschicht den zweiten Leitfähigkeitstyp auf und eine zumindest gebietsweise ausgebildete dritte metallische Anschlusskontaktschicht ist stoffschlüssig mit einer Oberseite der III-V-Halbleiterpassivierungsschicht verbunden.

In einer weiteren Ausführungsform umfassen das Halbleiterkontaktgebiet und das Driftgebiet und/oder eine hochdotierte Halbleiterkontaktschicht GaAs auf oder bestehen aus GaAs.

In einer anderen Weiterbildung weist die stapelförmige hochsperrende III-V-Halbleiterleistungsdiode eine weitere Passivierungsschicht auf, wobei die weitere Passivierungsschicht eine Oberseite der III-V-Halbleiterpassivierungsschicht, eine dem Driftgebiet zugewandte Seitenfläche der III-V-Halbleiterpassivierungsschicht, eine an die Seitenfläche der III-V-Halbleiterpassivierungsschicht angrenzende Oberseite des Driftgebiets und einen Randbereich der Oberseite des Halbleiterkontaktgebiets überdeckt.

Vorzugsweise umfasst die weitere Passivierungsschicht Si₃N₄ und / oder SiO₂ und / oder SiNOₓ / oder Polyimid oder besteht aus Si₃N₄ und / oder SiO₂ und / oder SiNOₓ und / oder Polyimid.

In einer anderen Ausführungsform bedeckt die weitere Passivierungsschicht nur die Oberseite der III-V-Halbleiterpassivierungsschicht, sowie eine dem Driftgebiet zugewandte Seitenfläche der III-V-Halbleiterpassivierungsschicht und einen Teil einer an die Seitenfläche der III-V-Halbleiterpassivierungsschicht angrenzenden Oberseite des Driftgebiets.

Das Halbleiterkontaktgebiet ist vorzugsweise durch Implantation oder Diffusion von Fremdatomen, z.B. Zn oder Mg, in das Driftgebiet erzeugt. Die Tiefe des Halbleiterkontaktgebiets beträgt vorzugsweise mindestens 0,2 µm und höchstens 1 µm oder höchstens 5 µm.

Die Oberseite des Halbleiterkontaktgebiets weist in alternativen Ausführungsformen einen kreisförmigen oder einen ovalen oder einen mehreckigen, z.B. einen achteckigen, quadratischen oder rechteckigen, Umfang auf.

In einer anderen Weiterbildung weist die stapelförmige hochsperrende III-V-Halbleiterleistungsdiode eine Pufferschicht auf, wobei die Pufferschicht unterhalb der Unterseite des Driftgebiets und oberhalb der ersten metallischen Anschlusskontaktschicht angeordnet ist und an einer dem Driftgebiet zugewandten Oberseite die erste Gitterkonstante und an einer Unterseite eine von der ersten Gitterkonstanten abweichenden zweite Gitterkonstante aufweist.

In einer weiteren Ausführungsform weist die hochsperrende III-V-Halbleiterleistungsdiode eine Substratschicht auf, wobei die Substratschicht unterhalb der Unterseite des Driftgeblets und oberhalb der ersten metallischen Anschlusskontaktschicht angeordnet ist und die erste Gitterkonstante oder eine von der ersten Gitterkonstanten abweichenden zweiten Gitterkonstante aufweist.

Die Pufferschicht ermöglicht es, ein Wachstumssubstrat mit einer von einer Gitterkonstanten der Bauelementschichten abweichenden Gitterkonstanten zu wählen.

So ermöglicht beispielsweise InGaAs im Vergleich zu GaAs mit einer geringeren Vorwärtsspannung zu arbeiten, wodurch sich im Durchlassfall die Verluste durch die III-V-Halbleiterleistungsdiode stark reduzieren lassen.

Mit einer höheren Beweglichkeit verbessern sich die transienten elektrischen Eigenschaften, wie beispielsweise die Schaltfrequenz und der Serienwiderstand der III-V Halbleiterleistungsdiode.

Mittels der Verwendung eines metamorphen Puffers lässt sich trotzdem ein günstiges III-V Material, wie beispielsweise GaAs oder Ge als Substrat verwenden. In einer Ausführungsform entspricht also die erste Gitterkonstante der Gitterkonstanten von InGaAs und die zweite Gitterkonstante der Gitterkonstanten von Ge oder GaAs.

In einer weiteren Ausführungsform weist die stapelförmige hochsperrende III-V-Halbleiterdiode eine Halbleiterzwischenschicht mit einer Dotierstoffkonzentration von 1•10¹⁴ cm⁻³ bis 1•10¹⁶ cm⁻³ und einer Schichtdicke von höchstens 50 µm oder von höchstens 20 µm auf, wobei entweder die Halbleiterzwischenschicht unterhalb des Driftgebiets und oberhalb einer hochdotierten Halbleiterkontaktschicht des zweiten Leitfähigkeitstyps angeordnet ist und den zweiten Leitfähigkeitstyp aufweist oder die Halbleiterzwischenschicht zwischen dem hochdotierten Halbleiterkontaktgebiet und dem Driftgebiet ausgebildet ist und den ersten Leitfähigkeitstyp aufweist.

In einer Weiterbildung weist die stapelförmige hochsperrende III-V-Halbleiterdiode sowohl die Halbleiterzwischenschicht des zweiten Leitfähigkeitstyps zwischen dem Driftgebiet und einer hochdotierten Halbleiterkontaktschicht des zweiten Leitfähigkeitstyps als auch die Halbleiterzwischenschicht des ersten Leitfähigkeitstyps zwischen dem Driftgebiet und dem Halbleiterkontaktgebiet auf.

Alternativ ist die metamorphe Pufferschichtfolge durch eine dotierte Zwischenschicht eines ersten Leitfähigkeitstyps mit einer Dotierstoffkonzentration kleiner als 5•10¹⁵ N/cm³ und mit einer ersten Gitterkonstante und mit einer Dicke zwischen 1 µm und 30 µm von der Driftschicht beabstandet ist.

Vorzugsweise umfasst die Zwischenschicht In alternativer Weiterbildungen als Dotierstoffe Zink und / oder Silizium und/oder Kohlenstoff und/oder Tellur. Die Dotierstoffkonzentration der Zwischenschicht ist kleiner als die Dotierstoffkonzentration des unmittelbar an die Zwischenschicht angrenzenden hochdotierten Halbleiterkontaktbereichs, also entweder des Halbleiterkontaktbereichs oder einer hochdotierten Halbleiterkontaktschicht unterhalb des Driftgebiets. Insbesondere ist die Dotierstoffkonzentration der Zwischenschicht in einem Bereich zwischen einem Faktor 2 bis zu einem Faktor von vier Größenordnungen kleiner als die Dotierstoffkonzentration des unmittelbar an die Zwischenschicht angrenzenden hochdotierten Halbleiterkontaktbereichs.

Vorzugsweise ist die Dotierstoffkonzentration der Zwischenschicht größer als die Dotierstoffkonzentration der Driftschicht. Höchst vorzugsweise ist die Dotierstoffkonzentration der Zwischenschicht mindestens um einen Faktor 2 bis zu einem Faktor 100 oder mindestens um einen Faktor 10 bis zu einem Faktor 50 größer als die Dotierstoffkonzentration der Driftschicht.

Es versteht sich, dass sich der p-n Übergang der Halbleiterleistungsdiode gegebenenfalls zwischen der Driftschicht und der Zwischenschicht ausbildet, sofern eine Zwischenschicht ausgebildet ist und die Zwischenschicht einen von dem Driftgebiet abweichenden Leitfähigkeitstyp aufweist.

Beispielsweise ist es im Falle einer n-auf-p Struktur mit einem hoch n-dotierten Halbleiterkontaktgebiet, einem schwach n-dotierten Driftgebiet und einer unterhalb des Driftgebiets folgenden hoch p-dotierten Halbleiterkontaktschicht vorteilhaft, eine schwach p-dotierte Halbleiterzwischenschicht zwischen der hoch p-dotierten ersten Kontaktschicht und der schwach n-dotierten Schicht des Driftgebiets anzuordnen, um den Serienwiderstand zu reduzieren, die Durchbruchspannung zu erhöhen und eine bessere thermische Ankopplung zu erreichen.

In einer weiteren Weiterbildung weist das Driftgebiet den zweiten Leitfähigkeitstyp auf und die erste metallische Anschlusskontaktschicht ist mit der Unterseite des Driftgebiets oder mit einer Unterseite einer unterhalb des Driftgebiets angeordneten Pufferschicht oder mit einer Unterseite einer unterhalb des Driftgebiets angeordneten Substratschicht stoffschlüssig verbunden.

Anders ausgedrückt, weist die Halbleiterdiode keine hochdotierte Halbleiterkontaktschicht unterhalb des Driftgebiets aus und der p-n Übergang bildet sich zwischen dem Halbleiterkontaktgebiet und dem Driftgebiet aus.

In einer anderen alternativen Ausführungsform weist die hochsperrende III-V-Halbleiterdiode eine hochdotierte Halbleiterkontaktschicht des zweiten Leitfähigkeitstyps mit einer Dotierstoffkonzentration von mindestens 1•10¹⁷ cm⁻³ und der ersten Gitterkonstanten oder einer zweiten Gitterkonstanten auf, wobei die Halbleiterkontaktschicht unterhalb des Driftgebiets angeordnet ist und die erste metallische Anschlusskontaktschicht stoffschlüssig mit einer Unterseite der Halbleiterkontaktschicht verbunden ist. In einer Weiterbildung weist die Halbleiterkontaktschicht eine Schichtdicke von 5 µm - 200 µm auf.

Die Halbleiterkontaktschicht weist In einer ersten alternativen Ausführungsform die erste Gitterkonstante auf. Die Unterseite des Driftgebiets ist in einer Weiterbildung stoffschlüssig mit der Oberseite der Halbleiterkontaktschicht verbunden.

In einer zweiten alternativen Ausführungsform weist die Halbleiterkontaktschicht die zweite Gitterkonstante auf, wobei zwischen der Halbleiterkontaktschicht und dem Driftgebiet eine Pufferschicht mit der ersten Gitterkonstanten an einer dem Driftgebiet zugewandten Oberseite und der zweiten Gitterkonstante an einer der Halbleiterkontaktschicht zugewandten Unterseite angeordnet ist.

Vorzugsweise weist die metamorphe Pufferschicht eine Dicke zwischen 2 µm und 5 µm und eine Dotierung zwischen 1•10¹⁷ cm⁻³ bis 1•10¹⁹ cm⁻³ auf. Es versteht sich, dass die metamorphe Pufferschicht wenigstens drei Halbleiterschichten und höchstens fünfzehn Halbleiterschichten umfasst, wobei sich die Gitterkonstanten der Halbleiterschichten der metamorphen Pufferschicht von Halbleiterschicht zu Halbleiterschicht im Allgemeinen ändern.

Die metamorphe Pufferschicht lässt sich auch dazu verwenden, das Driftgebiet epitaktisch auf einem Substrat zu erzeugen, wobei das Substrat die zweite Gitterkonstante aufweist. Alternativ ermöglicht die Pufferschicht das Ausbilden einer Halbleiterkontaktschicht aus einem Material mit der zweiten Gitterkonstanten.

In einer Weiterbildung ist die hochdotierte metamorphe Pufferschichtfolge von dem zweiten Leitfähigkeitstyp oder von dem ersten Leitfähigkeitstyp und weist eine Dotierstoffkonzentration größer als 5•10¹⁷ cm⁻³ oder größer als 1•10¹⁷ cm⁻³ oder größer als 3•10¹⁶ cm⁻³ oder größer als 1•10¹⁶ cm⁻³ auf.

In einer weiteren Ausführungsform ist die Halbleiterkontaktschicht als Substratschicht oder als Pufferschicht ausgebildet. Anders ausgedrückt weist eine einzige Halbleiterschicht oder Halbleiterschichtfolge sowohl die Funktion und Eigenschaften der Halbleiterkontaktschicht als auch die der Substratschicht oder die der Pufferschicht auf bzw. erfüllt jeweils beide Funktionen, insbesondere die vorgenannten Funktionen.

Die Erfindung wird nachfolgend unter Bezugnahme auf die Zeichnungen näher erläutert. Hierbei werden gleichartige Teile mit identischen Bezeichnungen beschriftet.

Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigen, die
- Figur 1: eine Schnittansicht einer ersten Ausführungsform einer stapelförmigen hochsperrenden III-V-Halbleiterleistungsdiode,
- Figur 2: eine Aufsicht auf die erste Ausführungsform der stapelförmigen hochsperrenden III-V-Halbleiterleistungsdiode,
- Figur 3: eine Schnittansicht einer zweiten Ausführungsform der stapelförmigen hochsperrenden III-V-Halbleiterleistungsdiode,
- Figur 4: eine Querschnittansicht einer dritten Ausführungsform der stapelförmigen hochsperrenden III-V-Halbleiterleistungsdiode,
- Figur 5: eine Querschnittansicht einer vierten Ausführungsform der stapelförmigen hochsperrenden III-V-Halbleiterleistungsdiode,
- Figur 6: eine Querschnittansicht einer fünften Ausführungsform der stapelförmigen hochsperrenden III-V-Halbleiterleistungsdiode,
- Figur 7: eine Querschnittansicht einer sechsten Ausführungsform der stapelförmigen hochsperrenden III-V-Halbleiterleistungsdiode.

Bei allen Abbildungen ist aus Gründen der Übersichtlichkeit jeweils nur eine Schnittansicht bzw. eine Querschnittsansicht einer III-V- Halbleiterleistungsdiode dargestellt.

Es sei jedoch angemerkt, dass alle in der Schnittansicht abgebildeten III-V-Halbleiterleistungsdioden in einer Draufsicht entweder einen quadratischen oder einen rechteckigen oder einen runden Umfang aufweisen.

Anders ausgedrückt, in der Draufsicht weisen die III-V- Halbleiterleistungsdiode die gleichen Schichtfolgen wie in der jeweiligen Querschnittsansicht auf.

Auch gilt, dass die Halbleiterkontaktbereiche und die Halbleiterschichten jeweils eine III-V Verbindung umfassen oder aus den Elementen einer III-V Verbindung bestehen, wobei jeder Halbleiterbereich und jede Halbleiterschicht jeweils eine Oberseite und eine Unterseite aufweisen.

Die Oberseite zeigt hierbei jeweils in Richtung des an der Oberseite des Schichtstapels angeordneten Metallkontakts bzw. metallischen Anschlusskontakts, während die Unterseite jeweils in Richtung des an der Unterseite des Schichtstapels angeordneten Metallkontakts bzw. metallischen Anschlusskontakts zeigt.

Auch sei für alle Ausführungsformen angemerkt, dass der Ausdruck "Zwischenschicht" mit dem Ausdruck "Zwischenbereich" vorzugsweise synonym verwendet wird.

Jedoch wird mit dem Ausdruck "Zwischenbereich" oder mit dem Ausdruck "Halbleiterkontaktbereich" eine im Allgemeinen wannenförmige Ausbildung bezeichnet, dem hingegen ist mit dem Ausdruck "Zwischenschicht" oder "Halbleiterkontaktschicht" im Allgemeinen jeweils eine Schicht mit zumindest einer planen Unterseite und / oder mit einer planen Oberseite bezeichnet.

Insbesondere umfassen abgebildete metamorphe Puffer eine Vielzahl von III-V-Halbleiterschichten oder bestehen aus einer Vielzahl von III-V-Halbleiterschichten, wobei sich die Gitterkonstante im Allgemeinen von III-V Halbleiterschicht zu III-V Halbleiterschicht ändert.

Unter einer Vielzahl wird vorliegend eine Anzahl von mindestens drei und maximal dreißig oder eine Anzahl von mindestens fünf und maximal zehn Halbleiterschichten verstanden. Des Weiteren ist der metamorphe Puffer jeweils möglichst niederohmig, d.h. hochdotiert ausgeführt.

Des Weiteren gilt für alle dargestellten Ausführungsformen, dass die III-V-Halbleiterleistungsdiode eine Oberseite und eine Unterseite aufweisen, wobei vorzugsweise mittels einer an der Unterseite ausgebildeten metallischen Anschlusskontaktschicht die III-V- Halbleiterleistungsdiode als sogenanntes "Die" auf einer als Metallrahmen bzw. Metallträger auch "Leadframe" genanntem Unterlage angeordnet sind.

Eine möglichst große insbesondere ganzflächige Ausbildung der metallischen Anschlusskontaktschicht an der Unterseite verbessert die thermische Ankopplung an die Unterlage.

Es versteht sich, dass die Begriffe "oben", "oberhalb", "unten" und "unterhalb" nur zur Anordnung der einzelnen Gebiete und Schichten relativ zueinander dienen und keine absolute Richtung angeben.

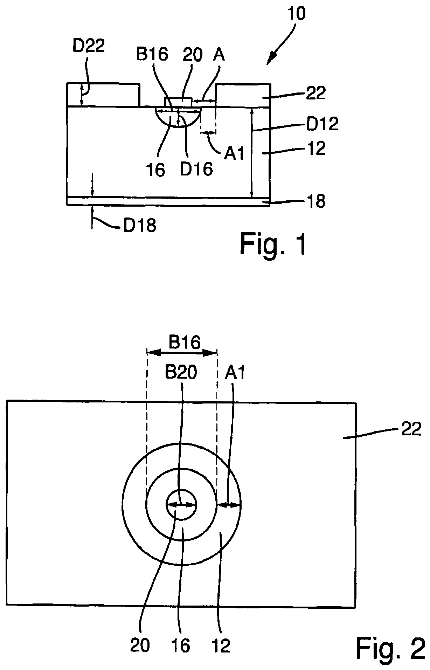

Die Abbildung der Figur 1 zeigt eine stapelförmige hochsperrende III-V-Halbleiterleistungsdiode 10 mit einem Driftgebiet 12, einem hochdotierten Halbleiterkontaktgebiet 16, einer ersten metallischen Anschlusskontaktschicht 18, einer zweiten metallischen Anschlusskontaktschicht 20 sowie einer III-V-Halbleiterpassivierungsschicht.

Das Driftgebiet 12 ist mit Dotierstoffen eines zweiten Leitfähigkeitstyps mit einer Dotierstoffkonzentration von höchstens 1016 cm⁻³ dotiert und weist eine Schichtdicke D12 von mindestens 10 µm auf.

Die erste metallische Anschlusskontaktschicht 18 ist als Metallschicht mit einer Schichtdicke D18 auf einer Unterseite des Driftgebiets 12 ausgebildet und mit dem Driftgebiet 12 stoffschlüssig verbunden.

Das hochdotierte Halbleiterkontaktgebiet 16 weist Dotierstoffe eines ersten Leitfähigkeitstyps mit einer Dotierstoffkonzentration von mindestens 5•10¹⁸ cm⁻³ auf und erstreckt sich von der Oberseite des Driftgebiets 12 wannenförmig in das Driftgebiet 12 hinein.

Das Halbleiterkontaktgebiet 16 ist vorzugsweise mittels eines Masken- und Implantationsprozesses hergestellt. Hierbei werden Dotierstoffe in einen Bereich des ansonsten niedrig oder sehr niedrig dotierten Driftgebiets 12 eingebracht, wobei vorzugsweise die Dotierstoffe mittels eines Temperaturprozesses aktiviert werden.

Das hochdotierte Halbleiterkontaktgebiet 16 und das Driftgebiet 12 bilden eine gemeinsame Oberfläche aus, wobei die Oberseite des Halbleiterkontaktgebiets 16 eine Breite B16 entlang der gemeinsamen Oberfläche und eine Tiefe D16 in das Driftgebiet 12 hinein aufweist.

Die zweite metallische Anschlusskontaktschicht 20 ist auf dem Halbleiterkontaktgebiet 16 angeordnet, wobei die zweite metallische Anschlusskontaktschicht 20 einen möglichst konzentrisch angeordneten Teil der Oberseite des Halbleiterkontaktgebiets 16 überdeckt.

Die zweite metallische Anschlusskontaktschicht 20 ist somit in einer Projektion senkrecht zu der Oberseite des Driftgebiets 12 konzentrisch zu dem Halbleiterkontaktgebiet 16 angeordnet und vollständig von dem Halbleiterkontaktgebiet 16 umgeben.

In einem Abstand A1 zu der Oberseite des Halbleiterkontaktgebiets 16 ist die erste III-V-Halbleiterpassivierungsschicht 22 auf der Oberseite des Driftgebiets 12 angeordnet und mit der Oberseite stoffschlüssig verbunden. Die III-V-Halbleiterpassivierungsschicht 22 weist eine Schichtdicke D22 auf.

In der Abbildung der Figur 2 ist eine Aufsicht auf die erste Ausführungsform der stapelförmigen hochsperrenden III-V-Halbleiterleistungsdiode dargestellt. Im Folgenden werden nur die Unterschiede zu der Abbildung der Figur 1 erläutert.

Die Oberseite des Halbleiterkontaktgebiets 16 weist einen kreisförmigen Umfang und einen Durchmesser B16 auf. Die zweite Anschlusskontaktschicht 20 weist ebenfalls einen kreisförmigen Umfang mit einem Durchmesser B20 kleiner als der Durchmesser B16 auf und ist zu der Oberseite des Halbleiterkontaktgebiets 16 konzentrisch angeordnet.

Die Oberseite des Halbleiterkontaktgebiets 16 ist von einem freiliegenden Abschnitt der Oberseite des Driftgebiets 12 umgeben, wobei der freiliegende Abschnitt durchgehend einem zu dem ersten Abstand A1 etwas größeren Entfernung A aufweist. Die restliche Oberfläche des Driftgebiets 12 ist vollständig von der III-V-Halbleiterpassivierungsschicht 22 überdeckt.

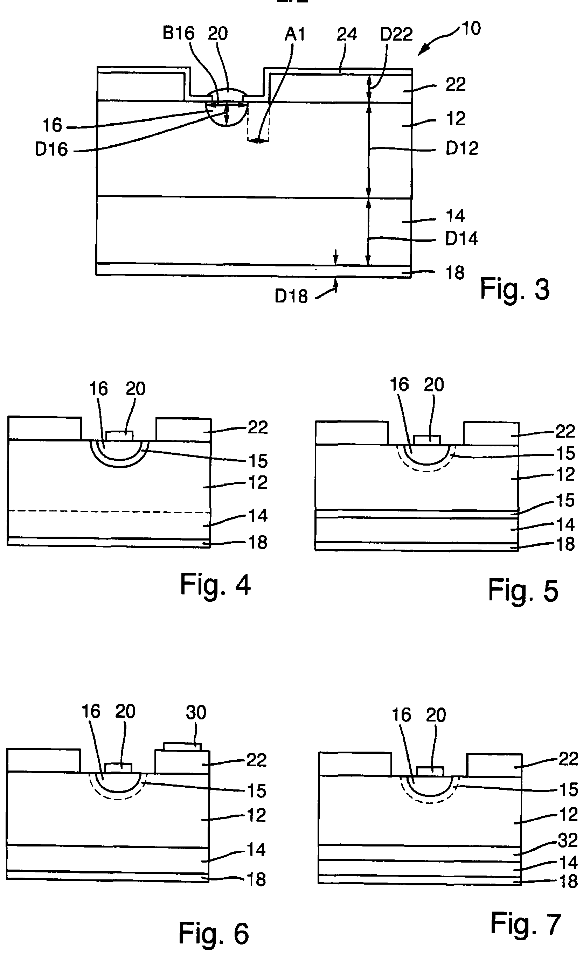

In der Abbildung der Figur 3 ist eine Schnittansicht einer zweiten Ausführungsform der stapelförmigen hochsperrenden III-V-Halbleiterleistungsdiode dargestellt. Im Folgenden werden nur die Unterschiede zu der Abbildung der Figur 1 erläutert.

Zwischen der Unterseite des Driftgebiets 12 und der Oberseite der ersten metallischen Anschlusskontaktschicht 18 ist eine mit Dotierstoffen des zweiten Leitfähigkeitstyps hoch-dotierte Halbleiterkontaktschicht 14 mit einer Dotierstoffkonzentration von mindestens 5•10¹⁸ cm⁻³ und einer Schichtdicke D14 von höchstens 10 µm bis 200 µm angeordnet und mit den beiden angrenzenden Schichten jeweils stoffschlüssig verbunden.

Eine Oberseite der III-V-Halbleiterpassivierungsschicht 22 ist von einer weiteren Passivierungsschicht 24, z.B. eine Nitridschicht oder einer Oxynitridschicht oder einer Oxidschicht oder einer Polyimidschicht, überdeckt. Die weitere Passivierungsschicht 24 erstreckt sich außerdem über einen das Halbleiterkontaktgebiet 16 umgebenden und nicht von der III-V-Halbleiterpassivierungsschicht 24 überdeckten Teil der Oberseite des Driftgebiets 12 sowie über einen Randbereich der Oberseite des Halbleiterkontaktgebiets 16 und über zu dem Halbleiterkontaktgebiet 16 ausgerichteten Seitenflächen der III-V-Halbleiterpassivierungsschicht 22.

Das Driftgebiet 12 weist entweder denselben Leitfähigkeitstyp wie die Halbleiterkontaktschicht 14 oder denselben Leitfähigkeitstyp wie das Halbleiterkontaktgebiet 16 auf, wobei der erste Leitfähigkeitstyp n und der zweite Leitfähigkeitstyp p ist oder der erste Leitfähigkeitstyp p und der zweite Leitfähigkeitstyp n ist.

In der Abbildung der Figur 4 ist eine Schnittansicht einer dritten Ausführungsform der stapelförmigen hochsperrenden III-V-Halbleiterleistungsdiode dargestellt. Im Folgenden werden nur die Unterschiede zu der Abbildung der Figur 1 erläutert.

Zwischen dem Halbleiterkontaktgebiet 16 und dem Driftgebiet 12 ist eine dotierte Zwischenschicht 15 des ersten Leitfähigkeitstyps ausgebildet. Die Zwischenschicht 15 ist ebenfalls wannenförmig ausgebildet, so dass das Halbleiterkontaktgebiet 16 allseitig zu dem Driftgebiet 16 beabstandet ist.

Die Zwischenschicht 15 weist eine Dotierung kleiner als das hochdotierte Halbleiterkontaktgebiet 16 und größer als das Driftgebiet 16 auf und ist stoffschlüssig mit dem Halbleiterkontaktgebiet 16 und dem Driftgebiet 16 verbunden. Die Zwischenschicht 15 weist eine Dotierstoffkonzentration kleiner als 5•10¹⁵ cm⁻³, die erste Gitterkonstante und eine Dicke zwischen 1 µm und 30 µm auf.

Optional (gestrichelt dargestellt) weist die Halbleiterdiode 10 die Halbleiterkontaktschicht 14 In Figur 3 auf. Es versteht sich, dass die dargestellte Ausführungsform außerdem auch mit der weiteren Passivierungsschicht kompatibel ist, diese also in einer Weiterbildung ebenfalls aufweist.

In der Abbildung der Figur 5 ist eine Schnittansicht einer vierten Ausführungsform der stapelförmigen hochsperrenden III-V-Halbleiterleistungsdiode dargestellt. Im Folgenden werden nur die Unterschiede zu den Abbildungen der Figur 1 und der Figur 4 erläutert.

Die Zwischenschicht 15 ist schichtförmig zwischen dem Driftgebiet 12 und der hochdotierten Halbleiterkontaktschicht 14 angeordnet und weist den zweiten Leitfähigkeitstyp auf.

Optional (gestrichelt dargestellt) weist die Halbleiterdiode 10 zusätzlich die Zwischenschicht 15 zwischen Halbleiterkontaktgebiet 16 und Driftgebiet 12 In Figur 4 auf.

In der Abbildung der Figur 6 ist eine Schnittansicht einer fünften Ausführungsform der stapelförmigen hochsperrenden III-V-Halbleiterleistungsdiode dargestellt. Im Folgenden werden nur die Unterschiede zu der Abbildung der Figur 1 erläutert.

In der fünften Ausführungsform weist das Driftgebiet 12 den ersten Leitfähigkeitstyp, also den Leitfähigkeitstyp des Halbleiterkontaktgebiets auf. Die III-V-Halbleiterpassivierungsschicht 22 weist dagegen einen sich von dem Leitfähigkeitstyp des Driftgebiets 12 unterscheidenden Leitfähigkeitstyp, also den zweiten Leitfähigkeitstyp auf.

Zusätzlich ist auf einer Oberseite der III-V-Halbleiterpassivierungsschicht 22 eine zumindest Gebietswelse ausgebildete dritte metallische Anschlusskontaktschicht 30 angeordnet und mit der Oberseite der III-V-Halbleiterpassivierungsschicht 22 stoffschlüssig verbunden.

In der Abbildung der Figur 7 ist eine Schnittansicht einer sechsten Ausführungsform der stapelförmigen hochsperrenden III-V-Halbleiterleistungsdiode dargestellt. Im Folgenden werden nur die Unterschiede zu der Abbildung der Figur 1 erläutert.

Die hochsperrende III-V-Halbleiterleistungsdiode 10 weist zusätzlich zu der hochdotierten Halbleiterkontaktschicht 14 noch eine Pufferschicht 32 auf, wobei die Pufferschicht 32 an einer Oberseite die erste Gitterkonstante und an einer Unterseite eine zweite Gitterkonstante aufweist.

Die Oberseite der Pufferschicht 32 ist stoffschlüssig mit der Unterseite des Driftgebiets 12 verbunden und die Unterseite der Pufferschicht 32 ist stoffschlüssig mit der Oberseite der hochdotierten Halbleiterkontaktschicht 14 verbunden. Die Halbleiterkontaktschicht 14 weist die zweite Gitterkonstante auf.

In einer alternativen, nicht dargestellten Ausführungsform weist das hochsperrende III-V-Halbleiterleistungsdiode die Pufferschicht 32, aber keine Halbleiterkontaktschicht 14 auf, so dass die erste metallische Anschlusskontaktschicht 18 stoffschlüssig mit der Unterseite der Pufferschicht 32 verbunden ist.

Ebenfalls nicht dargestellt sind weitere Ausführungsformen, bei denen das hochsperrende III-V-Halbleiterleistungsdiode 10 statt der Pufferschicht 32 eine Substratschicht mit der ersten Gitterkonstanten oder zusätzlich zu der Pufferschicht 32 und unterhalb der Pufferschicht 32 angeordnet eine Substratschicht mit der zweiten Gitterkonstanten aufweist.

Es wird angemerkt, dass auch die hochsperrenden III-V-Halbleiterleistungsdiode In den Ausführungsformen der Figuren 1 und 4 bis 7 die weiteren Passivierungsschicht 24 aufweisen können (nicht dargestellt).

## Patentansprüche

1. Stapelförmige hochsperrende III-V-Halbleiterleistungsdiode, aufweisend
- eine zumindest gebietsweise ausgebildete zweite metallische Anschlusskontaktschicht (20),
- ein hochdotiertes Halbleiterkontaktgebiet (16) eines ersten Leitfähigkeitstyps mit einer Dotierstoffkonzentration von mindestens 1•10¹⁸ cm⁻³ und mit einer ersten Gitterkonstanten und einer ersten Energiebandlücke,
- ein Driftgebiet (12) des ersten Leitfähigkeitstyps oder eines zweiten Leitfähigkeitstyps mit einer Dotierstoffkonzentration von 8•10¹¹ - 1•10¹⁴ cm⁻³, mit der ersten Gitterkonstanten und einer Schichtdicke von 10 µm - 100 µm und
- eine erste metallische Anschlusskontaktschicht (18), wobei
- die vorgenannten Gebiete und Schichten in der genannten Reihenfolge angeordnet sind,
- das Halbleiterkontaktgebiet (16) wannenförmig mit einer Oberseite und einer sich in das Driftgebiet (12) hinein erstreckenden Tiefe ausgebildet ist,
- die Unterseite der zweiten metallischen Anschlusskontaktschicht (14) stoffschlüssig mit der Oberseite des Halbleiterkontaktgebiets (16) verbunden ist,
**dadurch gekennzeichnet, dass**
- die hochsperrende III-V-Halbleiterleistungsdiode eine III-V-Halbleiterpassivierungsschicht (22) mit der ersten Gitterkonstanten und einer sich von der ersten Energiebandlücke unterscheidenden zweiten Energiebandlücke aufweist, wobei
- die III-V-Halbleiterpassivierungsschicht (22) den ersten oder den zweiten Leitfähigkeitstyp und eine Dotierstoffkonzentration von 1•10¹⁴ - 1•10¹⁸ cm⁻³ aufweist,
- die III-V-Halbleiterpassivierungsschicht (22) in einem ersten Abstand (A1) von mindestens 0,5 µm oder von mindestens 5 µm oder von mindestens 10 µm oder von mindestens 20 µm oder von mindestens 40 µm zu der Oberseite des hochdotierten Halbleiterkontaktgebiets (16) auf der Oberseite des Driftgebiets (12) angeordnet und mit der Oberseite des Driftgebiets (12) stoffschlüssig verbunden ist.

2. Stapelförmige hochsperrende III-V-Halbleiterleistungsdiode nach Anspruch 1, **dadurch gekennzeichnet, dass** die III-V-Halbleiterpassivierungsschicht (22) eine Schichtdicke von 0,1 µm - 10 µm aufweist.

3. Stapelförmige hochsperrende III-V-Halbleiterleistungsdiode nach einem der vorangegangenen Ansprüche, **dadurch gekennzeichnet, dass** die III-V-Halbleiterpassivierungsschicht (22) InGaP oder AlGaAs oder InGaAsP aufweist oder aus InGaP oder AlGaAs oder InGaAsP besteht.

4. Stapelförmige hochsperrende III-V-Halbleiterleistungsdiode nach einem der vorangegangenen Ansprüche, **dadurch gekennzeichnet, dass** der erste Abstand (A1) der III-V-Halbleiterpassivierungsschicht (22) zu dem Halbleiterkontaktgebiet mindestens 50% oder mindestens 75% der Schichtdicke des Driftgebiets beträgt.

5. Stapelförmige hochsperrende III-V-Halbleiterleistungsdiode nach einem der vorangegangenen Ansprüche, **dadurch gekennzeichnet, dass** die III-V-Halbleiterpassivierungsschicht (22) in einer Projektion senkrecht zu der Oberseite des Halbleiterkontaktgebiets das Halbleiterkontaktgebiet vollständig umschließt.

6. Stapelförmige hochsperrende III-V-Halbleiterleistungsdiode nach einem der vorangegangenen Ansprüche, **dadurch gekennzeichnet, dass** das Driftgebiet (12) den ersten Leitfähigkeitstyp und die III-V-Halbleiterpassivierungsschicht (22) den zweiten Leitfähigkeitstyp aufweist und eine zumindest gebietsweise ausgebildete dritte metallische Anschlusskontaktschicht stoffschlüssig mit einer Oberseite der III-V-Halbleiterpassivierungsschicht (22) verbunden ist.

7. Stapelförmige hochsperrende III-V-Halbleiterleistungsdiode nach einem der vorangegangenen Ansprüche, **dadurch gekennzeichnet, dass** die III-V-Halbleiterpassivierungsschicht (22) auf dem Driftgebiet (12) epitaktisch erzeugt ist und/oder das Driftgebiet (12) auf einer Halbleiterkontaktschicht oder auf einer Pufferschicht oder auf einer Substratschicht epitaktisch erzeugt ist.

8. Stapelförmige hochsperrende III-V-Halbleiterleistungsdiode nach einem der vorangegangenen Ansprüche, **dadurch gekennzeichnet, dass** das Halbleiterkontaktgebiet (16) und das Driftgebiet (12) und/oder eine Halbleiterkontaktschicht (14) GaAs aufweisen oder aus GaAs bestehen.

9. Stapelförmige hochsperrende III-V-Halbleiterleistungsdiode nach einem der vorangegangenen Ansprüche, **dadurch gekennzeichnet, dass** die stapelförmige hochsperrende III-V-Halbleiterleistungsdiode eine weitere Passivierungsschicht aufweist, wobei die weitere Passivierungsschicht eine Oberseite der III-V-Halbleiterpassivierungsschicht (22), eine dem Driftgebiet (12) zugewandte Seitenfläche der III-V-Halbleiterpassivierungsschicht (22), eine an die Seitenfläche der III-V-Halbleiterpassivierungsschicht (22) angrenzende Oberseite des Driftgebiet (12) und einen Randbereich der Oberseite des Halbleiterkontaktgebiets (16) überdeckt.

10. Stapelförmige hochsperrende III-V-Halbleiterleistungsdiode nach Anspruch 9, **dadurch gekennzeichnet, dass** die weitere Passivierungsschicht Si₃N₄ und / oder SiO₂ und / oder SiNOₓ / oder Polyimid umfasst oder aus Si₃N₄ und / oder SiO₂ und / oder SiNOₓ und / oder Polyimid besteht.

11. Stapelförmige hochsperrende III-V-Halbleiterleistungsdiode nach einem der vorangegangenen Ansprüche, **dadurch gekennzeichnet, dass** das Halbleiterkontaktgebiet durch Implantation oder Diffusion von Fremdatomen in das Driftgebiet (12) erzeugt ist.

12. Stapelförmige hochsperrende III-V-Halbleiterleistungsdiode nach einem der vorangegangene Ansprüche, **dadurch gekennzeichnet, dass** die Tiefe des Halbleiterkontaktgebiets (16) mindestens 0,2 µm und höchstens 1 µm oder höchstens 5 µm beträgt.

13. Stapelförmige hochsperrende III-V-Halbleiterleistungsdiode nach einem der vorangegangenen Ansprüche, **dadurch gekennzeichnet, dass** die Oberseite des Halbleiterkontaktgebiets (16) einen kreisförmigen oder einen ovalen oder einen mehreckigen Umfang aufweist.

14. Stapelförmige hochsperrende III-V-Halbleiterieistungsdiode nach einem der vorangegangenen Ansprüche, **dadurch gekennzeichnet, dass** der erste Leitfähigkeitstyp n ist und der zweite Leitfähigkeitstyp p ist oder dass der erste Leitfähigkeitstyp p ist und der zweite Leitfähigkeitstyp n ist.

15. Stapelförmige hochsperrende III-V-Halbleiterleistungsdiode nach einem der vorangegangenen Ansprüche, **dadurch gekennzeichnet, dass** die stapelförmige hochsperrende III-V-Halbleiterleistungsdiode eine Pufferschicht aufweist, wobei die Pufferschicht (34) unterhalb der Unterseite des Driftgebiets (12) und oberhalb der erste metallischen Anschlusskontaktschicht angeordnet ist und an einer dem Driftgebiet (12) zugewandten Oberseite die erste Gitterkonstante und an einer Unterseite eine von der ersten Gitterkonstanten abweichenden zweite Gitterkonstante aufweist.

16. Stapelförmige hochsperrende III-V-Halbleiterleistungsdiode nach einem der vorangegangenen Ansprüche, **dadurch gekennzeichnet, dass** die hochsperrende III-V-Halbleiterleistungsdiode eine Substratschicht aufweist, wobei die Substratschicht unterhalb der Unterseite des Driftgebiets und oberhalb der ersten metallischen Anschlusskontaktschicht angeordnet ist und die erste Gitterkonstante oder eine von der ersten Gitterkonstanten abweichende zweite Gitterkonstante aufweist.

17. Stapelförmige hochsperrende III-V-Halbleiterleistungsdiode nach einem der vorangegangenen Ansprüche, **dadurch gekennzeichnet, dass** die stapelförmige hochsperrende III-V-Halbleiterdiode eine Halbleiterzwischenschicht (15) mit einer Dotierstoffkonzentration von 1•10¹⁴ cm⁻³ - 1•10¹⁶ cm⁻³ und einer Schichtdicke (D34) von höchstens 50 µm oder höchstens 20 µm aufweist, wobei die Halbleiterzwischenschicht (15) unterhalb des Driftgebiets (12) und oberhalb einer Halbleiterkontaktschicht (14) des zweiten Leitfähigkeitstyps angeordnet ist und den zweiten Leitfähigkeitstyp aufweist und/oder die Halbleiterzwischenschicht (34) zwischen dem Halbleiterkontaktgebiet (16) und dem Driftgebiet (12) ausgebildet ist und den ersten Leitfähigkeitstyp aufweist.

18. Stapelförmige hochsperrende III-V-Halbleiterleistungsdiode nach einem der vorangegangenen Ansprüche, **dadurch gekennzeichnet, dass** das Driftgebiet (12) den zweiten Leitfähigkeitstyp aufweist und die erste metallische Anschlusskontaktschicht (18) mit der Unterseite des Driftgebiets (12) oder mit einer Unterseite einer unterhalb des Driftgebiets (12) angeordneten Pufferschicht (32) oder mit einer Unterseite einer unterhalb des Driftgebiets (12) angeordneten Substratschicht stoffschlüssig verbunden ist.

19. Stapelförmige hochsperrende III-V-Halbleiterleistungsdiode nach einem der Ansprüche 1 bis 17, **dadurch gekennzeichnet, dass** die hochsperrende III-V-Halbleiterdiode eine hochdotierte Halbleiterkontaktschicht (14) des zweiten Leitfähigkeitstyps mit einer Dotierstoffkonzentration von mindestens 1•10¹⁷ cm⁻³ und der ersten Gitterkonstanten oder einer zweiten Gitterkonstanten aufweist, wobei die Halbleiterkontaktschicht unterhalb des Driftgebiets (12) angeordnet ist und die erste metallische Anschlusskontaktschicht (18) stoffschlüssig mit einer Unterseite der Halbleiterkontaktschicht (14) verbunden ist.

20. Stapelförmige hochsperrende III-V-Halbleiterleistungsdiode nach Anspruch 19, **dadurch gekennzeichnet, dass** die Halbleiterkontaktschicht eine Schichtdicke von 5 µm - 200 µm aufweist.

21. Stapelförmige hochsperrende III-V-Halbleiterleistungsdiode nach einem der Ansprüche 19 oder 20, **dadurch gekennzeichnet, dass** die Halbleiterkontaktschicht (14) die erste Gitterkonstante aufweist und die Unterseite des Driftgebiets (12) stoffschlüssig mit der Oberseite der Halbleiterkontaktschicht (14) verbunden ist.

22. Stapelförmige hochsperrende III-V-Halbleiterleistungsdiode nach einem der Ansprüche 19 oder 20, **dadurch gekennzeichnet, dass** die Halbleiterkontaktschicht (14) die zweite Gitterkonstante aufweist und zwischen der Halbleiterkontaktschicht (14) und dem Driftgebiet (12) eine Pufferschicht (32) mit der ersten Gitterkonstanten an einer dem Driftgebiet (12) zugewandten Oberseite und der zweiten Gitterkonstante an einer der Halbleiterkontaktschicht (14) zugewandten Unterseite angeordnet ist.

23. Stapelförmige hochsperrende III-V-Halbleiterleistungsdiode nach einem der Ansprüche 19 bis 22, **dadurch gekennzeichnet, dass** die Substratschicht oder die Pufferschicht (32) als Halbleiterkontaktschicht (14) als ausgebildet ist.
